# EUROPÄISCHE PATENTSCHRIFT

(11) **EP 0 969 119 B1**
(45) Veröffentlichungstag und Bekanntmachung des Hinweises auf die Patenterteilung: **26.03.2008**
(21) Anmeldenummer: 99110115.5
(22) Anmeldetag: 25.05.1999
(51) Int. Cl.: C23C 14/56, H01L 21/00, C23C 16/54

(54) **Anordnung sowie deren Verwendung zum Beschichten von Gegenständen**
Device and its use for coating of objects
Procédé et son utilisation pour le revêtement d'objets

(30) Priorität: 29.05.1998 DE 19824040
(43) Veröffentlichungstag der Anmeldung: 05.01.2000
(73) Patentinhaber: SCHOTT Solar GmbH, 63755 Alzenau (DE)
(72) Erfinder: Lauinger, Thomas, 63843 Niedernberg (DE)
(74) Vertreter: Stoffregen, Hans-Herbert

(56) Entgegenhaltungen:
- GB-A- 2 143 910
- US-A- 3 931 789
- US-A- 4 412 771
- US-A- 5 538 560
- US-A- 5 626 677
- PATENT ABSTRACTS OF JAPAN vol. 010, no. 296 (C-377), 8. Oktober 1986 (1986-10-08) & JP 61 113767 A (NISSIN ELECTRIC CO LTD), 31. Mai 1986 (1986-05-31)
- PATENT ABSTRACTS OF JAPAN vol. 1996, no. 04, 30. April 1996 (1996-04-30) & JP 07 316814 A (SUMITOMO HEAVY IND LTD), 5. Dezember 1995 (1995-12-05)
- PATENT ABSTRACTS OF JAPAN vol. 010, no. 296 (C-377), 8. Oktober 1986 (1986-10-08) & JP 61 113766 A (NISSIN ELECTRIC CO LTD), 31. Mai 1986 (1986-05-31)

## Beschreibung

Die Erfindung bezieht sich auf eine Anordnung sowie eine Verwendung dieser zum Beschichten von Gegenständen, insbesondere plattenförmigen Gegenständen wie Halbleiterbauelementen, vorzugsweise Si-Wafern mit Oberflächenschichten, umfassend eine Einrichtung zum Zuführen und Übergeben von zumindest einem unbeschichteten Gegenstand an eine Beschichtungseinrichtung wie -kammer sowie Entnahme und Wegführen eines beschichteten Gegenstandes aus bzw. von dieser.

In der Photovoltaikindustrie werden Anlagen zur Niederdruck-Gasphasenabscheidung unter anderem für die Herstellung von amorphen Dünnschichtsolarzellen und zur Herstellung dünner Oberflächenschichten auf kristallinen Solarzellen eingesetzt. Dabei wird die plasmaunterstützte Aktivierung der Reaktionsgase (PECVD, plasma-enhanced chemical vapor deposition) zunehmend gegenüber der thermischen Aktivierung bevorzugt, da letztere auf Grund der erforderlichen hohen Temperaturen (> 700 °C) für viele Anwendungszwecke ungeeignet ist (siehe z. B. US 5,626,677 oder Vossen, Kern, Thin Film Processes, Academic Press, Inc., London, 1978, S. 337-342 oder Rossnagel et al., Handbook of Plasma Processing Technology, Noyes Publications, New Jersey, 1990, S. 269-271 oder Popov, High Density Plasma Sources, Noyes Publications, New Jersey, 1995, S. 408-410).

Als industriell nutzbare PECVD-Anlage sind bekannt:
- Rohranlagen zur gleichzeitigen Oberflächenbeschichtung von über 100 kristallinen Siliziumwafern (Rossnagel et al., Handbook of Plasma Processing Technology, Noyes Publications, New Jersey, 1990, S. 269-271),
- geschlossene Durchlaufanlagen mit Schleusen zur Beschichtung von großflächigen Substraten (z. B. Glasscheiben) oder von großflächigen Paletten, die mit kleineren Siliziumwafern bestückbar sind, (JP 0 731 6814 A), und
- offene Durchlaufanlagen ohne bewegte Schleusen zur kontinuierlichen Beschichtung großflächiger Substrate wie z. B. Glasscheiben oder Stahlbändern (EP 0 574 178 A2).

Die zuvor genannten Anlagen zeigen jedoch im Hinblick auf eine kostengünstige Beschichtung von flächigen Gegenständen, insbesondere kristallinen Siliziumwafern erhebliche Nachteile.

In Rohranlagen wird ein langes Boot aus Graphitplatten mit bis zu 100 Si-Wafern bestückt und in ein beheiztes Quarzglasrohr gefahren. Die einzelnen Graphitplatten sind paarweise elektrisch verschaltet, so dass beim Anlegen einer elektrischen Spannung ein Plasma zwischen allen Platten brennt und zur Aktivierung der eingeleiteten Prozessgase führt.

Um einen hohen Durchsatz zu erzielen, sind mehrere alternierend nutzbare Plasmarohre und eine Vielzahl von "Waferbooten" erforderlich, was einen hohen Aufwand für das erforderliche Transportsystem der Boote bedeutet.

Die Beladung zerbrechlicher Siliziumwafer in die Boote über Roboterstationen ist ein sehr kostenintensiver Prozess, da viele verschiedene Positionen beladen werden müssen und der Abstand zwischen den einzelnen Platten des Bootes sehr gering ist.

Nicht nur die Wafer, sondern auch das benötigte Glasrohr wird mit SiN beschichtet. Dies erfordert bereits nach einer kleinen Zahl von Beschichtungen eine Unterbrechung, um die Wände des Glasrohres abzuätzen. Dazu sind teure und teilweise umweltgefährdende Ätzgase (CFCs) erforderlich.

Auf Grund der hohen Masse der Boote sind lange Aufheizzyklen erforderlich, die den Durchsatz der Anlage begrenzen.

In Rohranlagen kann nur mittels Parallelplattenplasma abgeschieden werden. Dies erfordert einen guten elektrischen Kontakt zwischen den Siliziumwafern und den Graphitplatten. Dieser Forderung zu genügen, bereitet mehr und mehr Probleme, da moderne (preiswerte) Siliziumwafer für die Photovoltaik nach Verfahren hergestellt werden, die in der Regel gewellte Substrate zur Folge haben (Bandziehverfahren) (siehe z. B. Haefer, Oberflächen- und Dünnschicht-Technologie, Teil I Beschichtungen von Oberflächen, Springer-Verlag Berlin 1987, S. 168-169).

Die homogene Beschichtung großer Wafer ist problematisch, da mit zunehmender Wafergröße eine homogene Gasverteilung über den Wafer und entlang des Bootes schwieriger wird.

Eine in-situ Qualitätskontrolle ist nicht möglich. Im Falle eines Anlagenfehlers geht der gesamte Batch (ca. 100 Si Wafer) verloren.

Geschlossene Durchlaufanlagen vermeiden viele Probleme von Rohranlagen. So ist z. B. der Einsatz moderner Plasmaquellen mit höherer Anregungsdichte/Abscheiderate möglich und es kann auf einen elektrischen Kontakt zum Wafer verzichtet werden. Die Problematik des Abätzens der Anlage ist unkritisch, da die Quelle z. B. seitlich einer vertikal laufenden Palette angebracht werden kann und somit abfallende Partikel nicht auf die Wafer treffen. Weiterhin kann durch den Einsatz von Remote Plasmaquellen eine hohe Qualität der Oberflächenschichten erzeugt werden. Trotz dieser Vorteile existieren dennoch Nachteile, die zu hohen Beschichtungskosten führen.

So ist die Durchlaufgeschwindigkeit der Paletten durch die maximale Beschichtungsrate der eingesetzten Plasmaquelle und durch die maximale Taktrate der verwendeten Schleusensysteme begrenzt. Eine Steigerung dieser beiden Größen ist mit derzeitiger Technik nur unter hohem Kostenaufwand möglich. Daher müssen die Paletten sehr groß gestaltet werden, um einen gewünschten Mindestdurchsatz der Anlage zu gewährleisten. Dies führt zu einer Reihe weiterer Probleme, da eine homogene Beschichtung der Palette mit zunehmender Größe immer schwieriger wird, die Bestückung einer großen Palette mit Einzelwafern - ähnlich wie bei Rohranlagen - eine aufwendige und teure Robotertechnik erfordert und die Gesamtanlage sehr große Dimensionen annimmt. Letzteres führt zwangsläufig zu hohen Investitionskosten.

Offene Durchlaufanlagen ohne bewegte Schleusen zur Beschichtung von kristallinen Siliziumwafern werden derzeit industriell nicht genutzt.

Hierbei müssten die Solarzellen in Trägern liegen, die in einer lückenlosen Endlosreihe selbstdichtend durch einen Kanal mit stufenweise abnehmendem Druck laufen. Dabei sind an die Solarzellenträger sehr hohe Anforderungen bezüglich ihrer mechanischen Stabilität zu stellen, damit sie eine ausreichende Dichtfunktion ausüben können. Dies ist im Hinblick auf die folgenden beiden Aspekte problematisch und führt deshalb zu hohen Herstellungskosten.

Die Träger werden starken Temperaturwechseln ausgesetzt, da die Beschichtung der Solarzellen in der Regel bei Temperaturen oberhalb 300 °C stattfindet. Es besteht die Gefahr, dass diese sich dabei verziehen.

Die Träger werden ebenfalls beschichtet. Dies verändert ihre Gleiteigenschaften und ihre geometrischen Abmaße. Zudem müssen die Träger im Rahmen von Wartungsarbeiten von dieser Oberflächenbeschichtung befreit werden. Für Träger, welche Präzisionswerkstücke darstellen, muss dies sehr schonend und folglich kostenintensiv durchgeführt werden. Falls aus konstruktiven Gründen (Reibung, thermische Ausdehnung, etc.) hohe Toleranzen der Spaltbreite zwischen Träger und Führungskanal unvermeidlich sind, entsteht eine relativ starke Luftströmung. Diese kann zwar von großen Vakuumpumpen vollständig abgeführt werden. Es bestehen jedoch die Gefahren, dass die Wafer durch die Strömung zu flattern beginnen und eventuell brechen oder dass sich eine übermäßige Anzahl von Partikeln in der Anlage ansammelt.

Der vorliegenden Erfindung liegt das Problem zugrunde, eine Anordnung sowie eine Verwerdung dieses zum Beschichten von insbesondere flächigen Gegenständen wie Si-Wafern sowie ein Verfahren zum Beschichten solcher zur Verfügung zu stellen, bei der die Gegenstände einzeln beschichtet werden sollen, bei gleichzeitiger Erholung einer hohen Taktrate. Ferner sollen die Gegenstände keinen hohen zu Zerstörungen führenden Luftströmen ausgesetzt werden. Auch soll es nicht erforderlich sein, die Gegenstände auf dichtenden Trägern zu transportieren.

Anordnungsgemäß wird das Problem im Wesentlichen dadurch gelöst, dass die Anordnung einen stirnseitig offenen Hohlzylinder und einen axial in diesem verschiebbaren Kolben mit zumindest einer Aufnahme mit gegenüberliegende Wandbereiche des Kolbens durchsetzender Kolbenöffnung umfasst, über die der Gegenstand einbringbar bzw. entnehmbar ist, dass der Hohlzylinder zumindest einen ersten Bereich und einen zweiten Bereich umfasst, die gegenüber dem Kolben abdichtbar sind, dass der erste Bereich im Stirnseitenbereich des Hohlzylinders verläuft und eine axiale Erstreckung aufweist, die größer als die Aufnahmeöffnung in ihrer axialen Erstreckung ist, dass der zweite Bereich evakuierbar ist und in Bezug auf den Kolben unabhängig von dessen Stellung gegenüber Atmosphärendruck abgedichtet ist, dass der zweite Bereich oder ein weiterer (dritter) evakuierbarer Bereich über eine Zylinderöffnung von einem Fördermittel als Übergabeeinrichtung bei auf diesen Bereich ausgerichteter Aufnahme des Kolbens zur Übergabe des Gegenstandes an die Beschichtungseinrichtung oder zur Aufnahme des Gegenstandes aus dieser durchsetzbar ist.

Insbesondere umfasst die Anordnung zwei parallel zueinander angeordnete Hohlzylinder mit jeweils zumindest einem ersten Bereich und einem zweiten Bereich, dass in dem jeweiligen Hohlzylinder jeweils ein Kolben mit zumindest einer Aufnahme mit jeweils gegenüberliegende Wandungen des Kolbens durchsetzenden Öffnungen axial verschiebbar ist, dass die Zylinder derart zueinander ausgerichtet sind, dass deren jeweilige Zylinderöffnung über eine erste Transportstrecke verbunden sind, die die Beschichtungseinrichtung durchsetzt, und dass bei auf die erste Transportstrecke ausgerichteter einen Aufnahme des Kolbens dieser den stirnseitig verlaufenden ersten Bereich des Hohlzylinders gegenüber Atmosphärendruck abdichtet. Insbesondere ist vorgesehen, dass der Kolben zwei Aufnahmen mit Aufnahmeöffnungen aufweist und dass bei auf die die Beschichtungseinrichtung durchsetzende Transportstrecke ausgerichteter einen Aufnahme die andere Aufnahme außerhalb des Hohlzylinders verläuft und dessen Aufnahmeöffnung auf eine weitere (zweite) Transportstrecke ausgerichtet ist. Dabei kann die zweite Transportstrecke eine Umsetzeinrichtung zur Entnahme von einem beschichteten Gegenstand bei gleichzeitiger Aufgabe eines unbeschichteten Gegenstandes von bzw. auf die zweite Transportstrecke umfassen. Mit anderen Worten weisen die erste und zweite Aufnahme jeden Kolbens einen Abstand zueinander derart auf, dass bei Ausrichtung einer Aufnahme auf die erste Transporteinrichtung die andere Aufnahme außerhalb des Zylinders verläuft und auf die zweite Transporteinrichtung ausgerichtet ist.

Nach einer Weiterbildung der Erfindung ist die einen beschichteten Gegenstand aufnehmende Aufnahme des Kolbens bei Ausrichtung dieser auf die zweite Transportstrecke von einer zweiten Fördereinrichtung durchsetzbar.

Dabei ist die erste und zweite Fördereinrichtung insbesondere eine Hubeinrichtung wie Hubzylinder, mittels der die Gegenstände bzw. die Gegenstände aufnehmende Träger aneinandergereiht entlang der ersten und zweiten Transportstrecke verschiebbar sind. Die erste Fördereinrichtung ist dabei mit dem Zylinder druckmäßig derart verbunden, dass gleiche Druckbedingungen herrschen.

Eine besonders hohe Taktrate ergibt sich dann, wenn die von der ersten Fördereinrichtung durchsetzte Zylinderöffnung in der Mitte des Zylinders verläuft und symmetrisch hierzu im jeweiligen Stirnbereich zumindest ein erster Bereich und im Bereich jeder Stirnseite eine zweite Transportstrecke verläuft, wobei der Kolben eine Länge derart aufweist, dass bei Ausrichtung einer der zwei Aufnahmen auf eine der zwei Transportstrecken der Kolben den im entferntliegenden Stirnbereich des Zylinders verlaufenden ersten Bereich abdichtet.

Durch die erfindungsgemäße Lehre wird ein offenes Durchlaufsystem zur Verfügung gestellt, mit Hilfe dessen Gegenstände einzeln beschichtet werden und in einer Endlosreihe durch einen durch den Zylinder gebildeten Kanal mit stufenweise oder in etwa stufenweise sich änderndem Druck transportiert werden, wobei die durch das Zusammenwirken des Kolbens und des Hohlzylinders gebildeten Schleusen ohne zusätzliche Ventile arbeiten, ohne dass jedoch die Gefahr besteht, dass starke Luftströmungen auftreten, die zu einer Beschädigung oder Zerstörung von Gegenständen führen könnten. Ferner ist es nicht erforderlich, die Gegenstände auf dichtenden Werkstückträgern zu transportieren, da diese aufgrund der erfindungsgemäßen Lehre eine Dichtfunktion zwischen Bereichen unterschiedlicher Drucke nicht ausüben müssen. Somit werden die üblicherweise in PECVD-Systemen vorhandenen Nachteile in Bezug auf Werkstückträger mit Dichtfunktion vermieden, da diese hohen Temperaturen, schnellen Temperaturwechseln und parasitärer Beschichtung ausgesetzt sind. Reinigungszyklen sind ohne Bedeutung.

Durch die erfindungsgemäße Lehre werden die Vorteile sowohl eines klassischen Schleusensystems über eine Zwischenkammer als auch einer offenen Durchlaufanlage mit stufenweiser Absenkung des Drucks benutzt, ohne deren Nachteile mit zu übernehmen. Dabei werden konstruktiv einfache Elemente benutzt, die hohe Standzeiten aufweisen und einer geringen Wartung bedürfen.

Gegebenenfalls können in axialer Richtung des Kolbens sich erstreckende Oberfächenvertiefungen vorgesehen sein, über die beim Verstellen des Kolbens eine Verbindung zwischen aufeinanderfolgenden und unterschiedliche Drucke aufweisenden Bereiche des Zylinders entsteht, um einen gewissen Druckausgleich zu ermöglichen, bevor die Aufnahme in einen neuen Bereich, d. h. ein Zylindersegment mit zum vorherigen Bereich abweichendem Druck eintritt. Die entsprechenden axialen Vertiefungen können durch Einfräsen in die Kolbenaußenwand hergestellt werden, und zwar ausgehend von den Aufnahmen zu beiden Seiten von deren Öffnungen.

Die Verwendung zuvor erläuterter Anordnung für ein Verfahren zum Beschichten von insbesondere flächigen Gegenständen im Durchlaufverfahren und insbesondere zum Beschichten von Si-Wafern z. B. durch Niederdruck-Gasphascnabscheidung zeichnet sich durch die Verfahrensschritte aus:
- Aufgabe eines unbeschichteten Gegenstandes auf eine erste Förderstrecke mittels einer Übergabeeinrichtung bei atmosphärischem Druck,
- Übergeben des unbeschichteten Gegenstandes auf eine zweite Förderstrecke, entlang der der atmosphärische Druck stufenweise auf einen Wert abgebaut wird, der dem zum Beschichten des Gegenstandes erforderlichem Druck angepasst ist,
- Übergabe des Gegenstandes an eine dritte eine Beschichtungseinrichtung durchlaufende Fördereinrichtung,
- Übergabe des beschichteten Gegenstandes an eine vierte Förderstrecke, innerhalb der der Druck stufenweise auf den atmosphärischen Druck angeglichen wird,
- Übergabe an die erste Förderstrecke und Entnahme des beschichteten Gegenstandes mittels der Übergabeeinrichtung.

Dabei bilden die vier Förderstrecken eine Endlosförderstrecke, innerhalb der im erforderlichen Umfang ein Druckabbau bzw. Druckaufbau erfolgt, wobei die Gegenstände in der ersten und dritten Förderstrecke aneinandergereiht durch Schieben transportiert werden. Dabei kann insbesondere die zweite und vierte Förderstrecke unbeschichtete Gegenstände von jeweils einer von zwei ersten Förderstrecken aufnehmen bzw. abgeben, die jeweils eine Übergabeeinrichtung aufweisen, wobei die zwei ersten Förderstrecken und die zweite, dritte und vierte Förderstrecke in sich geschlossene ringförmige oder eine Acht bildende Förderbahnen darstellen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines der Zeichnung zu entnehmenden bevorzugten Ausführungsbeispiels.

Es zeigen:
- Fig. 1 a - d: Prinzipdarstellungen von einer Anordnung zum Transportieren von zu beschichtenden Gegenständen mit eine Beschichtungseinrichtung enthaltendem Bereich,
- Fig. 2 a, b: eine Prinzipdarstellung eines beschichtete bzw. zu beschichtende Gegenstände aufnehmenden Kolbens und
- Fig. 3: einen den Kolben gemäß Fig. 2 aufnehmenden Hohlzylinder.

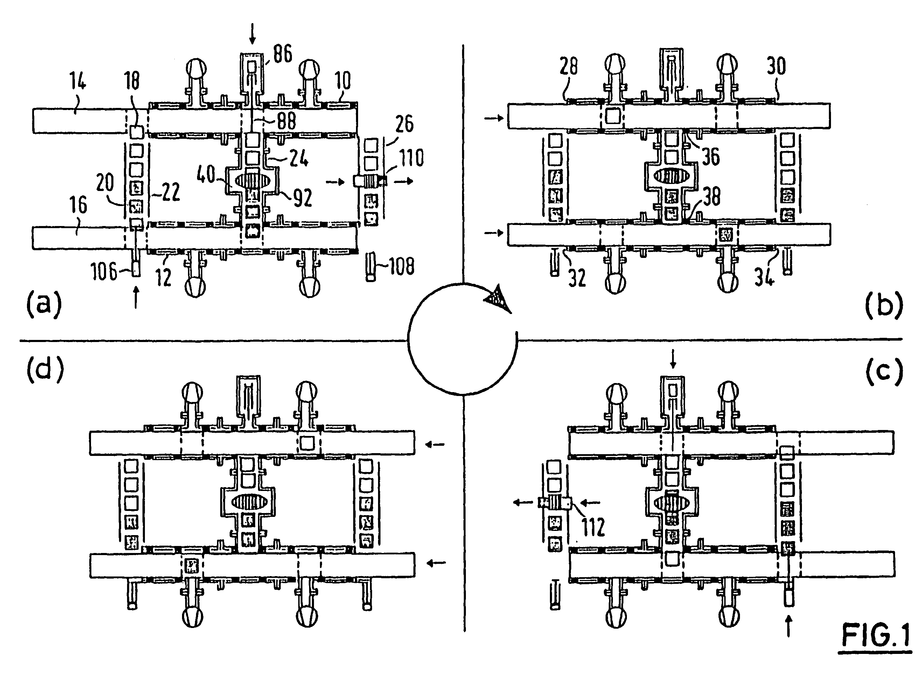

In Fig. 1 ist rein prinzipiell eine Anordnung zum Transportieren und Beschichten von flächigen Gegenständen dargestellt, wobei als flächige Gegenstände insbesondere Si-Wafer zu verstehen sind, die in einer Beschichtungszone insbesondere durch plasmaunterstützte Aktivierung von Reaktionsgasen (PECVD) beschichtet werden. Dabei sollen die Vorteile eines klassischen Schleusenverfahrens mit einer Zwischenkammer sowie einer offenen Durchlaufanlage mit stufenweiser Absenkung des Drucks genutzt werden. Sofern nachstehend nur von Wafern als Gegenstände gesprochen wird, so sollen diese einerseits deren Transport in Aufnahmen wie Trägern einschließen und andererseits die erfindungsgemäße Lehre nicht einschränken.

Wesentliche Bestandteile der Anordnung sind parallel zueinander angeordnete Hohlzylinder 10, 12, innerhalb der axial verschiebbar jeweils ein Hohlkolben 14, 16 verschiebbar ist, um unbeschichtete Wafer 18 bzw. beschichtete Wafer 20 von Förderstrecken 22, 24, 26 aufzunehmen bzw. an diese abzugeben. Zwei der Förderstrecken 22, 26 verlaufen im jeweiligen Stirnbereich 28, 30 bzw. 32, 34 der Hohlzylinder 10, 12, wohingegen die mittlere förderstrecke 24 über Öffnungen 36, 38 mit dem Mittelbereich des jeweiligen Hohlzylinders 10, 12 verbunden ist. Die Förderstrecke 24 umfasst dabei eine Beschichtungskammer 40, in der die Si-Wafer durch plasmaunterstützte Aktivierung von Reaktionsgasen beschichtet werden können. Hierzu ist es erforderlich, dass die Beschichtungszone 40 einen erforderlichen Unterdruck aufweist. Daher ist die Transportstrecke 24 druckdicht einerseits mit den Hohlzylindern 10, 12 verbunden und andererseits gegenüber der Atmosphäre abgedichtet.

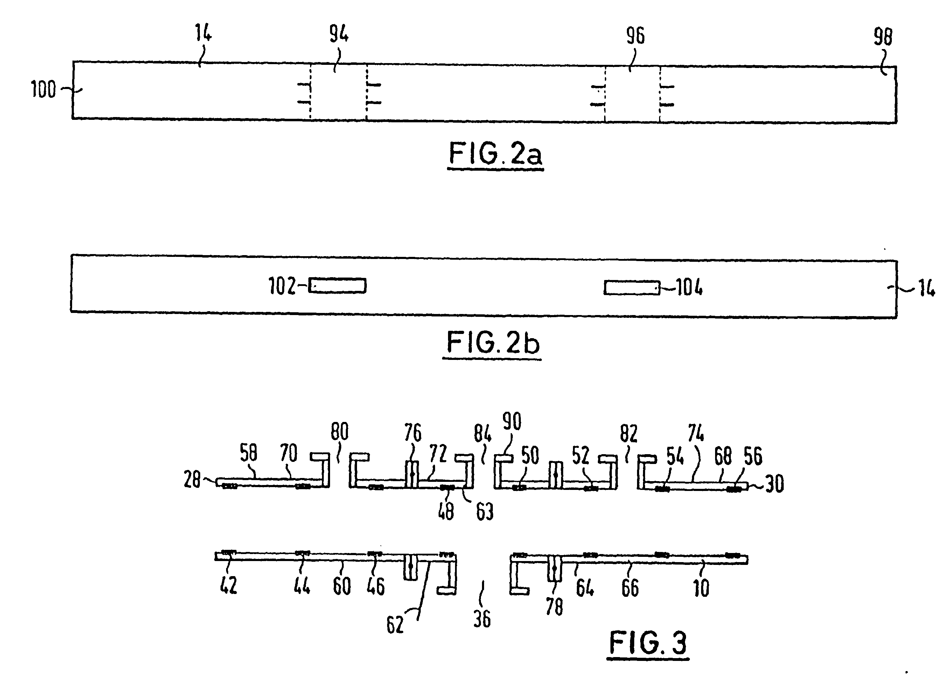

Wie die Detaildarstellung in Fig. 3 verdeutlicht, ist jeder Zylinder - in Fig. 3 ist beispielhaft der Zylinder 10 dargestellt - durch als Gleitringe wirkende Dichtringe 42, 44, 46, 48, 50, 52, 54, 56 in Bereiche 58, 60, 62, 63, 64, 66, 68 unterteilt. Ferner kann der Hohlzylinder 10 aus Segmenten 70, 72, 74 zusammengesetzt sein, die über Flansche 76, 78 verbunden sind.

Innerhalb des Hohlzylinders 10 ist der Hohlkolben 14 axial verschiebbar, wobei die Dichtringe 42, 44, 46, 48, 50, 52, 54, 56 dicht an dessen Außenfläche anliegen. Somit sind die Bereiche 58, 60, 62, 63, 64, 66, 68 gegeneinander abgedichtet, so dass in diesen unterschiedliche Drucke aufbaubar sind.

Hierzu sind innere Bereiche, im beschriebenen Ausführungsbeispiel die sich an die äußeren oder ersten Bereiche 58, 68 anschließenden zweite Bereiche 60, 66 über Flanschanschlüsse 80, 82 mit Vakuumpumpen verbindbar.

Der in der Mitte zwischen den Stirnbereichen 28, 30 des Zylinders 10 verlaufende Bereich 63 weist in gegenüberliegenden Wandungen Durchtrittsöffnungen 36, 84 auf, die von einem mittels eines Hubzylinders 86 betätigten Schieber 88 durchsetzbar sind. Hierzu geht über einen die Öffnung 84 umgebenden Flansch ein den Hubzylinder 86 aufnehmendes Gehäuse aus. Der die Öffnung 36 umgebende Flansch ist mit einem die Förderstrecke 24 umgebenden Gehäuse 92 verbunden.

Der Hohlkolben 14 weist zwei Aufnahmen oder Aufnahmekammern 94, 96 auf, die im Abstand zueinander dem Abstand zwischen der Öffnung 36 im Mittenbereich 63 und dem Stirnbereich 28, 30 des Hohlzylinders 10 derart angepasst ist, dass bei Ausrichtung einer der Aufnahmekammern 94, 96 auf die Öffnung 36 die andere Aufnahmekammer 96, 94 außerhalb des Hohlzylinders 10 in dessen einem Stirnbereich 28 bzw. 30 verläuft. Der Hohlkolben 14 erstreckt sich über die Aufnahmekammern 94, 96 hinaus über eine Länge dergestalt, dass bei Verlauf einer der Aufnahmekammern 94 oder 96 außerhalb des Zylinders 10 der gegenüberliegende Bereich des Hohlkolbens 14 dichtend am entferntliegenden äußeren Dichtring 56 bzw. 42 anliegt. Verläuft z. B. die Aufnahmekammer 94 außerhalb des Hohlzylinders 10 im Stirnbereich 28, so dichtet der Hohlkolben 14 mit seinem entferntliegenden Endbereich 98 den Hohlzylinder 10 über den Dichtring 56 ab. Umgekehrt liegt der Hohlkolben 14 mit seinem anderen Ende 100 dichtend an dem Dichtring 42 dann an, wenn die Kammer 96 außerhalb des Hohlzylinders 10 im Bereich des Stirnbereichs 30 verläuft.

Die Kammern 94, 96 sind über schlitzförmige Öffnungen 102, 104 zugänglich, wobei jede Öffnung 102, 104 durch in gegenüberliegenden Wandungen des Hohlzylinders 14 vorhandene Durchbrüche gebildet wird, so dass der Schieber 88 die Kammern 94, 96 dann durchsetzen kann, wenn diese auf die Öffnung 84, 36 des Hohlzylinders 10 ausgerichtet sind.

Selbstverständlich sind die Aufnahmen bzw. Aufnahmekammern 94, 96 gegeneinander und gegenüber den naheliegenden Stirnbereichen abgedichtet. Insbesondere weist jede Kammer 94, 96 eine axiale Erstreckung auf, die gleich oder geringfügig länger als die jeweilige Öffnung 102, 104 in ihrer axialen Erstreckung ist. Ferner sollte jede Kammer 94, 96 fluchtend zu den die Öffnungen 102, 104 bildenden Durchbrechungen in den Wandungen des Hohlkolbens 14, 16 verlaufende Zwischenwände oder gleichwirkende Elemente aufweisen, um einen stufenlosen Übergang von der jeweiligen Aufnahmekammer auf eine der zugeordneten Transportstrecken 22, 24, 26 sicherzustellen.

Wie die Fig. 1 verdeutlicht, verlaufen die ersten Förderstrecken 22, 26 unmittelbar im Bereich der Stirnbereiche 28, 30 der Hohlzylinder 10, 12, auf die die Kammer 94 oder 96 der Hohlzylinder 14, 16 dann ausgerichtet ist, wenn die andere Kammer 96 bzw. 94 der Öffnung 36 bzw. 38 des Hohlzylinders 10, 12 zugeordnet ist.

Der Hohlzylinder 12 unterscheidet sich von dem Hohlzylinder 10 dahingehend, dass allein die zu der Förderstrecke 24 führende Öffnung 38 vorhanden ist, wohingegen eine der Öffnung 84 entsprechende Öffnung fehlt. Diese wird beim Zylinder 12 nicht benötigt, da der Schieber 88 die Si-Wafer 18, 20 von dem Hohlzylinder 10 ausgehend durch die Förderstrecke 24 aneinandergereiht transportiert, also der Zylinder 12 von einer entsprechenden Fördereinrichtung nicht durchsetzt werden muss.

Demgegenüber müssen beide Hohlkolben 14, 16 diametral verlaufende Wandabschnitte durchsetzende Öffnungen 102, 104 aufweisen; denn der innerhalb des Hohlkolbens 10 verschiebbare Hohlzylinder 14 wird von dem Schieber 88, der auf die innere die Beschichtungseinrichtung 40 durchsetzende Förderstrecke 24 ausgerichtet ist, und die in dem Hohlkolben 16 vorhandenen Öffnungen 102, 104 werden von weiteren Schiebern 106, 108 außerhalb des Hohlzylinders 12 durchsetzt, die auf die ersten Förderstrecken 22, 24 ausgerichtet sind, um auf diesen angeordnete Si-Wafer zu fördern. Dies erfolgt ebenfalls dadurch, dass die Wafer 18, 20 bzw. die diese aufnehmenden Träger aneinandergereiht durch Schieben bzw. Gleiten bewegt werden.

Des Weiteren weist jede Transportstrecke 22, 26 eine Übergabevorrichtung 110, 112 auf, mittels der synchron unbeschichtete und beschichtete Si-Wafer übergeben werden. Dies wird durch die Pfeile im Bereich der Übergabestation 110, 112 angedeutet.

Die ersten Förderstrecken 22, 26, die in den Hohlzylindern 10, 12 axial verschiebbaren Hohlkolben 14, 16 sowie die die Beschichtungszone 40 aufweisende Förderstrecke 24 stellen ein geschlossenes Fördersystem dar, durch das kontinuierlich zu beschichtende und beschichtete Gegenstände wie Si-Wafer 18, 20 geführt werden.

Der Grundgedanke basiert dabei auf den Hohlkolben 14, 16, der in den beidseitig offenen Zylindern 10, 12 axial verschiebbar ist. Die Zylinder 10, 12 selbst sind durch die Gleit- und Dichtringe 42, 44, 46, 48, 50, 52, 54, 56 in die Bereiche 58, 60, 62, 63, 64, 66, 68 unterteilt, in denen von außen beginnend zur Mitte des Zylinders 10 hin ein Druckabbau und umgekehrt in dem Hohlzylinder 12 von innen nach außen ein Druckaufbau erfolgt. Jeder Hohlkolben 14, 16 besitzt zwei Aufnahmekammern 94, 96 zur Aufnahme unbeschichteter Gegenstände 18 (Kolben 14) bzw. beschichteter Gegenstände (Kolben 16). Die Kolben 14, 16 werden synchron derart bewegt, dass wechselseitig jeweils eine der Kammern 94, 96 vollständig aus dem Zylinder 10, 12 hinausfährt, um so bei Atmosphärendruck einen unbeschichteten Si-Wafer 18 mit einem Träger aufzunehmen (Kolben 14) bzw. einen beschichteten Si-Wafer 20 mit Träger aus dem Kolben 16 zu entfernen. Die synchrone Aufgabe bzw. Abgabe erfolgt dabei über die Schieber 106 und 108, und zwar abwechselnd jeweils in einem der Stirnbereiche 28, 30 der Hohlzylinder 10, 12.

Sobald in dem Hohlkolben 14, und zwar im Ausführungsbeispiel gemäß Fig. 1 a, in der Kammer 94 ein Si-Wafer eingebracht ist, wird der Kolben 14 nach rechts verschoben, so dass die Kammer 94 über eine oder mehrere Niederdruckstufen, die durch die Bereiche 58, 60, 62 gebildet werden, zu der Öffnung 36 gelangt, um mittels des Schiebers 88 den Si-Wafer auf die Transportstrecke 24 zu übergeben und entlang der Transportstrecke 24 zur Beschichtungszone 40 zu transportieren. Während die Aufnahmekammer 94 auf die Transportstrecke 24 ausgerichtet ist, ist die Kammer 96 auf die in der Zeichnung gemäß Fig. 1 rechte erste Transportstrecke 26 ausgerichtet, um ein unbeschichtetes Si-Wafer in zuvor beschriebener Art aufzunehmen.

Synchron mit dem Kolben 14 wird der Kolben 16 bewegt, wobei - wie zuvor ausgeführt - nach Aufnahme eines beschichteten Si-Wafers 20, also bei Ausrichtung einer der Kammern 94, 96 auf die Öffnung 38 und dem nachfolgenden axialen Verstellen des Kolbens 16 innerhalb des Zylinders 12 ein Druckaufbau erfolgt, um den beschichteten Si-Wafer 20 an eine der ersten Transportstrecken 22, 24 mittels der Schieber 106, 108 übergeben zu können.

Durch die synchrone Abstimmung der Kolben 14, 16 sowie der Fördereinrichtung in Form von Schiebern bzw. Hubzylindern 86, 106, 108 kann ein Beschichten von flächigen Gegenständen wie insbesondere Si-Wafern in hoher Taktfolge durchgeführt werden, ohne dass die Gefahr besteht, dass die Gegenstände durch insbesondere unerwünschte Zugluftausbildung beschädigt werden.

Mittels der erfindungsgemäßen Lehre ist ein schnelles Evakuieren der Kammern 94, 96 ohne mechanisch bewegte Schleusentore und Ventile möglich. Der die zu beschichtenden Gegenstände aufnehmende Träger selbst braucht keine Dichtfunktion zu übernehmen, wie dies bei Durchlaufsystemen üblicherweise der Fall ist. Hierdurch bedingt kann eine sehr einfache und kostengünstige Konstruktion zur Erzielung langer Standzeiten gewählt werden, da große Toleranzen bezüglich der Geometrie, ein Verzug durch Temperaturwechsel, Aufwachsen einer Oberflächenschicht zulässig sind. Auch kann eine Grobreinigung mittels Sandstrahlen erfolgen.

Die Hohlkolben selbst übernehmen den stirnseitigen Versatz der Träger für die zu beschichtenden Gegenstände innerhalb des Trägerkreislaufs. Hierdurch erfolgt eine Vereinfachung der Transportmechanik außerhalb des Niederdruckbereichs. Bei der Verwendung einer Flächenbeschichtungsquelle und bei einer ausreichend reibungsarmen Führung der Träger innerhalb der ersten und zweiten Transportstrecken kann der gesamte Transport der Träger mittels der Pneumatikzylinder bzw. der von diesen ausgehenden Schieber realisiert werden.

Sofern die Taktraten reduziert werden sollen, ist die erfindungsgemäße Lehre auch realisierbar, bei der nur eine erste Transportstrecke 22 oder 26 in einem der Stirnbereiche 28 oder 30 der Hohlzylinder 10, 12 vorhanden ist. In diesem Fall braucht der Hohlkolben 14, 16 jeweils nur eine Aufnahmekammer aufzuweisen. Auch kann die zweite Transportstrecke 24 zu der ersten Transportstrecke 22 bzw. 26 in Bezug auf diese im entferntliegenden Stirnbereich des Hohlzylinders 10, 12 verlaufen.

Um gegebenenfalls das Evakuieren bzw. das Belüften der Kammern 94, 96 zu vergleichmä-ßigen, können vom Bereich der Kammerbegrenzungen 94, 96 ausgehend in axialer Richtung der Hohlkolben 14, 16 verlaufende Außenwandungslängsschlitze durch z. B. Einfräsen eingebracht werden, wodurch beim Überschreiten der Dichtungsringe 42, 44, 46, 48 bzw. 56, 54, 52, 50 und umgekehrt bereits ein gewisser Druckausgleich zwischen den einzelnen Bereichen 58, 60, 62, 63 bzw. 68, 66, 64, 63 erfolgt, ohne dass eine unmittelbare Verbindung zwischen Atmosphärendruck und dem Bereich 60, 66 erfolgt, der an die Unterdruckpumpe angeschlossen ist.

## Patentansprüche

1. Anordnung zum Beschichten von flächigen Gegenständen (20), insbesondere Halbleiterbauelementen wie Si-Wafern mit Oberflächenschichten, umfassend eine Übergabeeinrichtung (86) zum Zuführen und Übergeben von zumindest einem unbeschichteten gegebenenfalls von einem Träger aufgenommenen Gegenstand an eine Beschichtungseinrichtung wie -kammer (40) sowie Entnahme und Wegführen eines beschichteten Gegenstandes aus bzw. von dieser,
**dadurch gekennzeichnet,**
**dass** die Anordnung einen stirnseitig offenen Hohlzylinder (10, 12) und einen axial in diesem verschiebbaren Kolben (14, 16) mit zumindest einer Aufnahme (94, 96) mit Aufnahmeöffnung umfasst, über die der Gegenstand einbringbar bzw. entnehmbar ist, dass der Hohlzylinder zumindest einen ersten Bereich (58, 68) und einen zweiten Bereich (60, 66, 63) umfasst, die gegenüber dem Kolben abdichtbar sind, dass der erste Bereich hohlzylinderstirnseitig verläuft und eine axiale Erstreckung aufweist, die größer als die Aufnahmeöffnung in ihrer axialen Erstreckung ist, dass der zweite Bereich in Bezug auf den Kolben unabhängig von dessen Stellung gegenüber Atmosphärendruck abgedichtet ist, dass der zweite Bereich oder ein anschließender weiterer Bereich über eine Hohlzylinderöffnung (84, 36) von einer ersten Fördereinrichtung als die Übergabeeinrichtung (86) bei auf diesen Bereich ausgerichteter Aufnahme des Kolbens zur Übergabe des Gegenstandes an die Beschichtungseinrichtung (40) oder zur Aufnahme des Gegenstandes aus dieser durchsetzbar ist.

2. Anordnung nach Anspruch 1,
**dadurch gekennzeichnet,**
**dass** der als Hohlkolben ausgebildete Kolben (14, 16) zwei Aufnahmen (94, 96) aufweist, dessen jeweilige Öffnung (100, 104) gegenüberliegende Wandbereiche des Hohlkolbens durchsetzt, wobei jede Aufnahme (94, 96) in axialer Richtung des Hohlkolbens (14, 16) gegenüber diesem abgedichtet sind.

3. Anordnung nach Anspruch 1 oder 2,
**dadurch gekennzeichnet,**
**dass** die Anordnung zwei parallel zueinander angeordnete Hohlzylinder (10, 12) mit jeweils einem ersten und einem zweiten Bereich (58, 68; 60, 66, 63) umfasst, in dem jeweils ein Kolben (14, 16) mit zumindest einer Aufnahme (94, 96) axial verschiebbar ist, dass die Zylinder derart zueinander ausgerichtet sind, dass deren jeweilige Zylinderöffnung (36, 84) über eine erste Transportstrecke (24) verbunden sind, die die Beschichtungseinrichtun; (40) durchsetzt, und dass bei auf die erste Transportstrecke ausgerichteter Aufnahme (94, 96) des Kolbens dieser den stirnseitig verlaufenden ersten Bereich (58, 68) des Hohlzylinders (10, 12) gegenüber Atmosphärendruck abdichtet.

4. Anordnung nach zumindest einem der vorhergehenden Ansprüche,
**dadurch gekennzeichnet,**
**dass** der Kolben (14, 16) zwei Aufnahmen (94, 96) mit Aufnahmeöffnungen (100, 104) aufweist und dass bei auf die die Beschichtungseinrichtung (40) durchsetzende Transportstrecke (24) ausgerichteter einen Aufnahme (94; 96) die andere Aufnahme (96, 94) außerhalb des Hohlzylinders (10, 12) verläuft und dessen Aufnahmeöffnung (104, 102) auf eine weitere (zweite) Transportstrecke (22, 26) ausgerichtet ist, wobei insbesondere die zweite Transportstrecke eine Umsetzeinrichtung (110, 112) zur Entnahme von einem beschichteten Gegenstand bei gleichzeitiger Aufgabe eines unbeschichteten Gegenstandes von bzw. auf die zweite Transportstrecke umfasst.

5. Anordnung nach zumindest einem der vorhergehenden Ansprüche,
**dadurch gekennzeichnet,**
**dass** zum Übergeben eines beschichteten Gegenstandes (20) auf die zweite Transportstrecke (22) die den beschichteten Gegenstand aufnehmende Aufnahme (94, 96) von einer zweiten auf die zweite Transportstrecke (22, 26) ausgerichteten Fördereinrichtung (106, 108) durchsetzbar ist.

6. Anordnung nach zumindest einem der vorhergehenden Ansprüche,
**dadurch gekennzeichnet,**
**dass** die erste und/oder zweite Fördereinrichtung (86, 106, 108) eine Hubeinrichtung wie Hubzylinder umfasst, mittels der bzw. des sämtliche auf der ersten und/oder zweiten Transportstrecke (24, 22, 26) befindliche Gegenstände bzw. die diese aufnehmenden Träger entlang dieser gleichzeitig verschiebbar sind, und dass die erste Fördereinrichtung in einem mit dem Hohlzylinder (10) druckdicht verbundenen Raum angeordnet ist.

7. Anordnung nach zumindest einem der vorhergehenden Ansprüche,
**dadurch gekennzeichnet,**
**dass** der Kolben (14, 16) eine erste und eine zweite Aufnahme (94, 96) mit jeweils diametral gegenüberliegende Wandbereiche des Kolbens durchsetzenden Öffnungen (100, 104) aufweist, und dass der Abstand zwischen der ersten und der zweiten Aufnahme derart ist, dass bei Ausrichtung einer der Aufnahmen auf die erste den Hohlzylinder (10, 12) durchsetzenden Transporteinrichtung die weitere zweite Aufnahme außerhalb des Zylinders verläuft und auf die zweite Transportstrecke (22, 26) ausgerichtet ist, wobei insbesondere zwischen Stirnbereichen (28, 30) jeweiligen Endes der Hohlzylinder (10, 12) jeweils eine zweite Transportstrecke (22, 26) verläuft.

8. Anordnung nach zumindest einem der vorhergehenden Ansprüche,
**dadurch gekennzeichnet,**
**dass** die erste die Beschichtungseinrichtung (40) durchsetzende Transportstrecke (24) mittig zwischen den zweiten Transportstrecken (22, 26) und parallel zu diesen verläuft und dass jeweils einer der Kolben (14, 16) zu beschichtende Gegenstände (18) und der andere Kolben beschichtete Gegenstände (20) aufnimmt und fördert, wobei der den Kolben mit den zu beschichtenden Gegenständen aufnehmende Hohlzylinder (10) von der ersten Fördereinrichtung (86) und der die beschichteten Gegenstände aufnehmende Kolben (16) von der auf die jeweilige zweite Transportstrecke (22, 26) ausgerichteten zweiten Fördereinrichtung (106, 108) durchsetzbar sind.

9. Anordnung nach zumindest einem der vorhergehenden Ansprüche,
**dadurch gekennzeichnet,**
**dass** der Hohlzylinder (10, 12) zumindest zwei an Unterdruckquellen wie Vakuumpumpen angeschlossene Bereiche (60, 66) aufweist, die gegenüber zu jeder Seite sich anschließenden Bereichen (64, 68, 58, 62) abgedichtet sind und jeweils zwischen der Zylinderöffnung (36) und einem der Stirnbereiche (28, 30) verlaufen, und dass vorzugsweise in axialer Richtung des Kolbens verlaufend von den Aufnahmen oder in etwa von den Aufnahmen (94, 96) ausgehend außenwandseitig Vertiefungen wie Rillen verlaufen, über die beim Verstellen des Kolbens (14, 16) eine druckmäßige Verbindung zwischen aufeinanderfolgenden Bereichen (58, 60; 60, 62; 62, 63; 63, 64; 64, 66; 66, 68) des Hohlzylinders (10, 12) erfolgt.

10. Verwendung der Anordnung nach Anspruch 1 für ein Verfahren zum Beschichten von insbesondere flächigen Gegenständen wie Si-Wafem im Durchlaufverfahren durch vorzugsweise plasmaunterstützte Aktivierung von Reaktionsgasen (PECVD) **gekennzeichnet durch** die Verfahrensschritte:
- Aufgabe eines unbeschichteten Gegenstandes mittels einer Übergabeeinrichtung auf eine erste Förderstrecke bei atmosphärischem Druck,
- Übergeben des unbeschichteten Gegenstandes von der ersten Förderstrecke auf eine zweite Förderstrecke, entlang der der atmosphärische Druck auf einen Druckwert stufenweise abgebaut wird, der an den zum Beschichten des Gegenstandes erforderlichen Druck angepasst ist,
- Übergabe des Gegenstandes an eine dritte die Beschichtungseinrichtung durchlaufende Förderstrecke,
- Übergabe des beschichteten Gegenstandes auf eine vierte Förderstrecke, innerhalb der Druck stufenweise auf den atmosphärischen Druck aufgebaut wird,
- Übergabe an die erste Förderstrecke und Entnahme des beschichteten Gegenstandes mittels der Übergabeeinrichtung.

11. Verwendung nach Anspruch 10,
**dadurch gekennzeichnet,**
**dass** die Förderstrecken eine Endlosförderstrecke bilden, wobei insbesondere die zwei ersten Förderstrecken, die zweite Förderstrecke, die dritte Förderstrecke und die vierte Förderstrecke zwei ringförmige geschlossene Förderstrecken oder eine achtförmige Förderstrecke mit jeweils gemeinsamer dritter Förderstrecke bilden.

12. Verwendung nach Anspruch 10,
**dadurch gekennzeichnet,**
**dass** die zweite Förderstrecke, innerhalb der während des Transports unbeschichteter Gegenstände ein stufenweiser oder im Wesentlichen stufenweiser Druckabbau erfolgt, unbeschichtete Gegenstände von jeweils einer von zwei ersten Förderstrecken aufnimmt, und dass die vierte Förderstrecke, innerhalb der während des Transports beschichtete Gegenstände ein stufenweiser oder im Wesentlichen stufenweiser Druckaufbau erfolgt, der die beschichten Gegenstände jeweils an eine der zwei ersten Förderstrecken abgibt.

## Claims

1. Arrangement for coating of plane objects (20), in particular semiconductor elements such as Si-Wafer with surface coatings, comprising a transfer means (86) for supplying and delivering at least one uncoated object, optionally received by a carrier, to a coating device such as chamber (40) as well as removal and leading away of a coated object out of or from the coating device or chamber,
**characterized in**
**that** the arrangement comprises a hollow cylinder (10, 12) open on the face and a piston (14, 16) axially moveable therein and having at least one receptacle (94, 96) with a receiving opening via which the object can be inserted and removed, respectively, that the hollow cylinder comprises at least a first area (58, 68) and a second area (60, 66, 63) which can be sealed relative to the piston, that the first area extends a the hollow cylinder face side and has an axial extent being greater than the axial extent of the receiving opening, that the second area is sealed against atmospheric pressure relative to the piston regardless of the piston position, that the second area or a following further area can be passed through via a hollow cylinder opening (84, 36) by a first conveying means as the transfer means (86) when the receptacle of the piston is aligned with this area for transfer of the object.

2. Arrangement according to claim 1,
**characterized in**
**that** the piston (14, 16) designed as hollow cylinder has two receptacles (94, 96), each opening of the piston having openings passing through opposite wall areas of the piston, whereby each of the receptacles is adapted to be sealed in axial direction of the piston relative to the same.

3. Arrangement according to claim 1 or 2,
**characterized in**
**that** the arrangement comprises two tubular pistons (10, 12) arranged in parallel to each other, each having a first and a second area (58, 68; 60, 66, 63), one piston (14, 16) with at least one receptacle (94, 96) being axially movable in each of which, that the cylinders are positioned to each other such that their respective cylinder opening (36, 84) is connected to one another via a first transport way (24) passing through the coating device (40), and that, with the receptacle (94, 96,) of the piston being aligned with the first transport way, the piston seals against atmospheric pressure the first area (58, 68) of the hollow cylinder (10, 12) running at the face side.

4. Arrangement according to at least one of the preceding claims,
**characterized in**
**that** the piston (14, 16) comprises two receptacles (94, 96) with receiving openings (100, 104) and that, when one receptacle (94; 96) is aligned with the transport way (24) passing through the coating device (40), the other receptacle (96, 94) extends outside the hollow cylinder (10, 12) and its receiving opening (104, 102) is aligned with a further (second) transport way (22, 26), whereby in particular the second transport way comprises a shifting means (110, 112) for removing a coated object from the second transport way with simultaneous feeding of an uncoated object to the second transport way.

5. Arrangement according to at least one of the preceding claims,
**characterized in**
**that**, for delivering a coated object (20) to the second transport way (22), the receptacle (94, 96) receiving the coated object can be passed through by a second conveying means (106, 108) aligned with the second transport way (22, 26).

6. Arrangement according to at least one of the preceding claims,
**characterized in**
**that** the first and/or second conveying means (86, 106, 108) comprises a lifting device like lifting cylinder, by means of which all objects located on the first and/or second transport way (24, 22, 26) and the carrier receiving said objects, respectively, are simultaneously moveable along said ways, and that the first conveying means is arranged in a space that is connected in pressure sealed manner with the hollow cylinder (10).

7. Arrangement according to at least one of the preceding claims,
**characterized in**
**that** the piston (14, 16) has a first and a second receptacle (94, 96) with openings (100, 104) each passing through diametrically opposing wall regions of the piston, and that the distance between the first and the second receptacle is such that when one of the receptacles is aligned with the first conveying means passing through the hollow cylinder (10, 12) the further second receptacle runs outside the cylinder and is aligned with the second transport way (22, 26), whereby in particular always a second transport way (22, 26) runs between the face regions (28, 30) of respective end of the hollow cylinders (10, 12).

8. Arrangement according to at least one of the preceding claims,
**characterized in**
**that** the first transport way (24) passing through the coating device (40) runs axially between and parallel to the second transport ways (22, 26), and that always one of the pistons (14, 16) receives and conveys objects (18) to be coated and the other piston receives and conveys coated objects (20), whereby the hollow cylinder (10) receiving the piston with the objects to be coated can be passed through by the first conveying means (86) and the piston (16) receiving the coated objects can be passed through by the second conveying means (106, 108) aligned with the respective second transport way (22, 26).

9. Arrangement according to at least one of the preceding claims,
**characterized in**
**that** the hollow cylinder (10, 12) has at least two regions (60, 66) connected to vacuum sources such as vacuum pumps, said regions being sealed against regions (64, 68, 58, 62) following each side and running in each case between the cylinder opening (36) and one of the face regions (28, 30), and that at the outer wall side depressions such as grooves, originating from the receptacles or approximately from the receptacles, extend preferably in axial direction of the piston, whereby via said grooves a pressure connection between successive regions (58, 60; 60, 62; 62, 63; 63, 64) of the hollow cylinder (10, 12) is made when moving the piston (14,16).

10. Use of the arrangement according to claim 1 for a method to coat in particular plane objects such as Si-wafers in a continuous operation by preferably plasma-supported activation of reaction gases (PECVD) **characterized by** the method steps:
- feeding an uncoated object by means of a transfer means to a first transport way at atmospheric pressure,
- delivering the uncoated object from the first transport way to a second transport way, along which the atmospheric pressure is reduced stepwise to a pressure value, that is adapted to the pressure required for coating the object,
- delivery of the object to a third transport way passing through the coating device,
- delivery of the coated object to a fourth transport way, within which pressure is built up stepwise to the atmospheric pressure,
- delivery to the first transport way and removal of the coated object by means of the transfer means.

11. Use according to claim 10,
**characterized in**
**that** the transport ways form an endless transport way, whereby in particular the two first transport ways, the second transport way, the third transport way and the fourth transport way form two annular closed transport ways or a figure-eight transport way with a shared third transport way in each case.

12. Use according to claim 10,
**characterized in**
**that** the second transport way receives uncoated objects from always one of two first transport ways, whereby within said second transport way a stepwise or essentially stepwise pressure suppression is made during the transport of uncoated objects, and that the fourth transport way delivers the coated objects in each case to one of the two first transport ways, whereby within said fourth transport way a stepwise or essentially stepwise pressure build-up happens during the transport of coated objects.

## Revendications

1. Dispositif de revêtement d'objets plats (20) notamment de composants semi-conducteurs tels que des plaquettes (Si) avec des couches de surface, comprenant une installation de transfert (86) pour fournir et transférer au moins un objet non revêtu, le cas échéant reçu par un support dans une installation telle qu'une chambre de revêtement (40) et enlèvement et évacuation de l'objet ainsi revêtu de cette chambre,
**caractérisé en ce que**
le dispositif comporte un cylindre creux (10, 12) ouvert du côté frontal et un piston (14, 16) coulissant axialement dans ce cylindre creux, le piston ayant au moins un logement (94, 96) avec un orifice de réception par lequel on peut introduire ou prélever l'objet,
le cylindre creux ayant au moins une première (58, 68) et une seconde zone (60, 66, 63) qui peuvent être séparées de manière étanche par rapport au piston,
la première zone étant du côté du cylindre creux et son extension axiale est supérieure à l'extension axiale de l'orifice de réception,
la seconde zone est séparée de manière étanche par rapport au piston, indépendamment de sa position, vis-à-vis de la pression atmosphérique,
la seconde zone ou une autre zone adjacente est traversée par une ouverture de cylindre creux (84, 36), par une première installation d'entraînement comme installation de transfert (86) lorsque le piston est reçu de manière dirigée vers cette zone, pour transférer l'objet à l'installation de revêtement (40) ou pour recevoir l'objet à partir de celle-ci.

2. Dispositif selon la revendication 1,
**caractérisé en ce que**
le piston (14, 16) réalisé comme piston creux comporte deux logements (94, 96) dont chaque ouverture (100, 104) traverse les zones de paroi opposées du piston creux, chaque logement (94, 96) étant séparé de manière étanche dans la direction axiale du piston creux (14, 16) par rapport à celui-ci.

3. Dispositif selon la revendication 1 ou 2,
**caractérisé en ce qu'**
il comprend deux cylindres creux (10, 12) installés parallèlement l'un par rapport à l'autre avec chaque fois une première et une seconde zone (58, 68 ; 60, 66, 63) dans laquelle coulisse axialement au moins un piston (14, 16) avec au moins un logement (94, 96), les cylindres étant alignés pour que leurs ouvertures (36, 84) soient reliées par l'intermédiaire d'un premier chemin de transport (24) qui traverse l'installation de revêtement (40), et
le logement (94, 96) du piston aligné sur ce premier chemin de transport, assure l'étanchéité vis-à-vis de la pression atmosphérique de la première zone (58, 68) du cylindre creux (10, 12) traversant celui-ci du côté frontal.

4. Dispositif selon au moins l'une des revendications précédentes,
**caractérisé en ce que**
le piston (14, 16) comporte deux logements (94, 96) avec des orifices de réception (100, 104), et
pour un logement (94, 96) aligné sur le chemin de transport (24) traversant l'installation de revêtement (40), l'autre logement (94, 96) passe à l'extérieur du cylindre creux (10, 12) et son orifice de réception (104, 102) est aligné sur l'autre (second) chemin de transport (22, 26),
notamment le second chemin de transport comporte une installation de conversion (110, 112) pour prélever un objet revêtu tout en introduisant simultanément un objet non revêtu par rapport au second chemin de transport.

5. Dispositif selon au moins l'une des revendications précédentes,
**caractérisé en ce que**
pour transférer un objet revêtu (20) au second chemin de transport (22), le logement (94, 96) qui reçoit l'objet revêtu est traversé par une seconde installation de transfert (106, 108) alignée sur le second chemin de transport (22, 26).

6. Dispositif selon au moins l'une des revendications précédentes,
**caractérisé en ce que**
la première et/ou la seconde installation de transfert (86, 106, 108) comprennent une installation de déplacement comme un cylindre de déplacement à l'aide du ou desquels tous les objets se trouvant sur le premier et/ou le second chemin de transfert (24, 22, 26) ou les supports qui reçoivent ces objets, peuvent être coulissés simultanément le long de ces chemins, et
la première installation de transfert comporte une chambre reliée de manière étanche à la pression ou au cylindre creux (10).

7. Dispositif selon au moins l'une des revendications précédentes,
**caractérisé en ce que**
le piston (14, 16) comporte un premier et un second logement (94, 96) avec des ouvertures (100, 104) traversant des zones de paroi du piston diamétralement opposées, et
la distance entre le premier et le second logement est telle qu'en alignant l'un des logements sur la première installation de transport traversant le premier cylindre creux (10, 12), le second logement se trouve à l'extérieur du cylindre et aligné sur le second chemin de transport (22, 26), et notamment entre les zones frontales (28, 30) de chaque extrémité des cylindres creux (10, 12) passe chaque fois un second chemin de transport (22, 26).

8. Dispositif selon au moins l'une des revendications précédentes,
**caractérisé en ce que**
le premier chemin de transport (24) traversant l'installation de revêtement (40) passe au milieu entre les seconds chemins de transport (22, 26) et parallèlement à ceux-ci, et
chaque l'un des pistons (14, 16) reçoit et transporte les objets à revêtir (18) et l'autre piston, les objets revêtus (20),
le cylindre creux (10) recevant le piston avec les objets revêtus de la première installation de transfert (86) et le piston (16) recevant les objets revêtus sont traversés par la seconde installation de transfert (106, 108) alignée sur chaque fois le second chemin de transport (22, 26).

9. Dispositif selon l'une des revendications précédentes,
**caractérisé en ce que**
le cylindre creux (10, 12) comporte au moins deux zones (60, 66) raccordées à des sources de dépression telles que des pompes à vide, rendues étanches par rapport aux zones (64, 68, 58, 62) adjacentes de chaque côté et passant chaque fois entre l'ouverture de cylindre (36) et une des zones frontales (28, 30), et
de préférence dans la direction axiale du piston, passant des logements ou sensiblement à partir des logements (94, 96), des cavités réalisées du côté de la paroi extérieure telles que des rainures réalisent lors du déplacement du piston (14, 16), une liaison de pression entre deux zones successives (58, 60 ; 60, 62 ; 62, 63 ; 63, 64 ; 64, 66 ; 66, 68) du cylindre creux (10, 12).

10. Utilisation du dispositif selon la revendication 1 pour un procédé de revétement, notamment d'objets plats tels que des plaquettes (Si) selon un procédé de passage par une activation assistée de préférence par du plasma de gaz de réaction (PECVD),
**caractérisée par** les étapes de procédé suivantes :
- fourniture d'un objet non revêtu à l'aide d'une installation de transfert à un premier chemin de transfert à pression atmosphérique ;
- transfert de l'objet non revêtu du premier chemin de transfert à un second chemin de transfert le long duquel la pression atmosphérique est diminuée étape par étape à un niveau de pression adapté à la pression nécessaire à l'application du revêtement sur l'objet ;
- transfert de l'objet à un troisième chemin de transfert passant par l'installation de revêtement ;
- transfert de l'objet revêtu à un quatrième chemin de transfert dans lequel on rétablit pas à pas la pression jusqu'à la pression atmosphérique ;
- transfert au premier chemin de transfert et prélèvement de l'objet revêtu à l'aide de l'installation de transfert.

11. Application selon la revendication 10,
**caractérisée en ce que**
les chemins de transfert constituent un chemin de transfert sans fin et notamment les deux premiers chemins de transfert, le second chemin de transfert, le troisième chemin de transfert et le quatrième chemin de transfert constituent deux chemins de transfert bouclés en anneau ou un chemin de transfert en forme de 8 avec chaque fois un troisième chemin de transfert commun.

12. Application selon la revendication 10,
**caractérisée en ce que**
le second chemin de transfert dans lequel, pendant le transport d'objets non revêtus, on établit une diminution de pression par étape ou pratiquement par étape, reçoit les objets non revêtus de l'un des deux premiers chemins de transfert,
le quatrième chemin de transfert sur lequel on établit pas à pas une pression ou pratiquement une pression au cours du transport des objets revêtus, fournit les objets revêtus à l'un des deux premiers chemins de transfert.
